# EUROPEAN PATENT APPLICATION

(11) **EP 3 030 063 A1**
(43) Date of publication of application: **08.06.2016**
(21) Application number: 14465526.3
(22) Date of filing: 05.12.2014
(51) Int. Cl.: H05K 5/00, H05K 5/06

(54) **Housing for electronic control unit**

(71) Applicant: Continental Automotive GmbH, 30165 Hannover (DE)
(72) Inventor: Kang, Alan, 48309, Rochester Hills, Michigan (US); Riepl, Thomas, 93077 Bad Abbach (DE); Tarnovetchi, Marius, 300516 Timisoara (RO)

(57) **Abstract**

A cover (12) for a housing (10) for an electronic control unit is disclosed. The cover (12) comprises a first border portion (21) for contacting a sealant (14) and a second portion (22a, 22b, 22c, 22d, 22e) adjacent to the first border portion (21). The deformability of the second portion (22a, 22b, 22c, 22d, 22e) is greater than the deformability of the first portion (21).

## Description

### Field of the invention

The present invention relates to a housing comprising two parts sealed together by means of a sealant for isolating an inner volume from an external environment. The housing of the present invention may be particularly used for electronic control units, for example for automotive applications.

### Art Background

Electronic components of an electronic control unit normally need to be protected from the surrounding environment which could be dangerous for the normal functioning of the electronic components, for example due to the presence of pollutants, such as dust, water or oil. For this reason electronic components may be contained in the inner volume of a housing, which is sealed to prevent contact with the external environment.

### Summary of the Invention

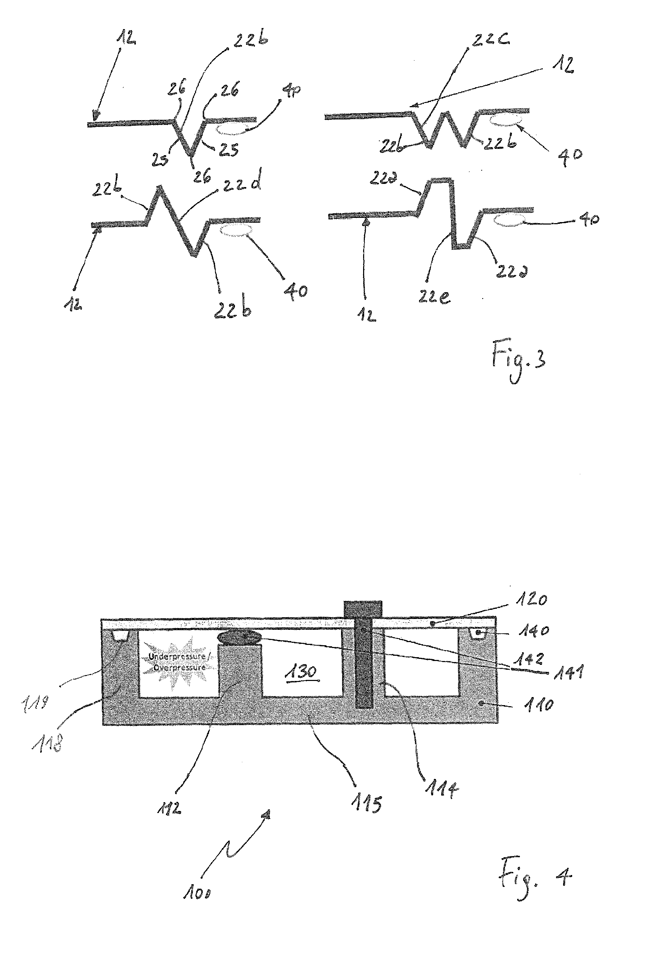

With reference to the sectional view in Fig. 4, a housing 100 for an electronic control unit comprises a bottom main body 110 and a cover 120 joined together. The main body 110 may be made of a plastic and/or metal material. The cover 120 may be made of a sheet-metal, of the same or of a different material with respect to the main body 110. In conventional housings 100, the cover 120 may be planar.

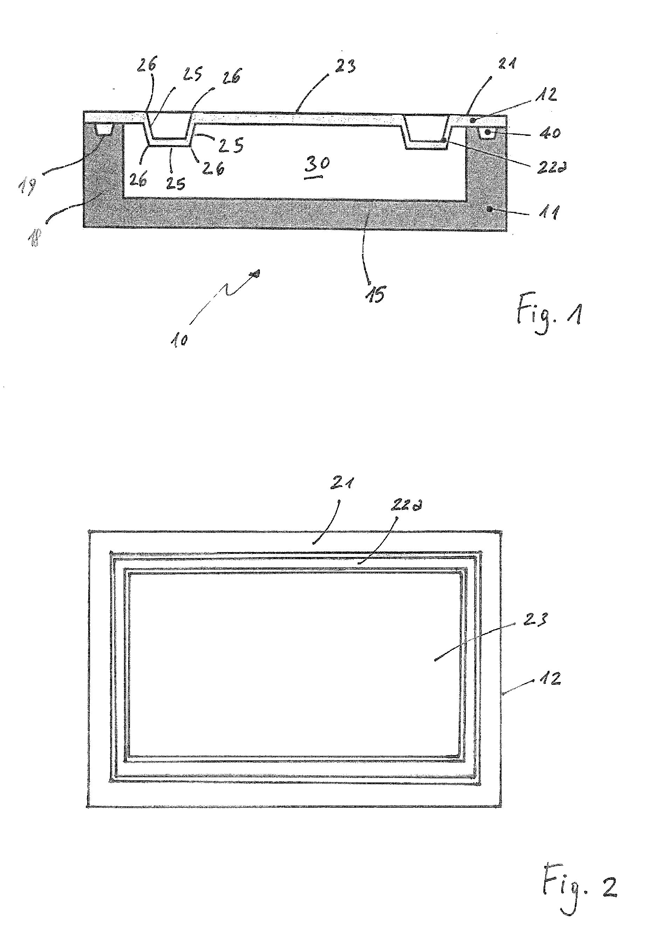

The main body 110 may include a base 115 and a perimeter wall 118 rising from the base 115. The base 115, seen from a top or bottom view (not represented) may have any shape, for example rectangular or circular. The perimeter wall 118 may be orthogonal (as shown in fig. 1) or may be otherwise inclined with respect to the base 115.

For example on top of the perimeter wall 118, the cover 120 is supported and fixed in order to create a hollow structure with an inner volume 130 delimited at least by the main body 110, in particular by the base 115 and the perimeter wall 118, and the cover 120. Further components of the electronic control unit - such as an electrical connector - may contribute to separate the inner volume 130 from the surroundings of the control unit. The inner volume 130 is subject to house a plurality of electronic components, in particular one or more circuit boards which are equipped with the electronic components.

For example on top of the perimeter wall 118, the main body 110 may include a seat 119 for a sealant material 140, for example constituted by a gasket, an O-ring or a viscous dispensed material. Preferably, the sealant is a so-called formed-in-place gasket or cured-in-place gasket. In this case, a fluid sealant is dispensed onto the seat 119 or onto the cover 120 and cured subsequent to joining the cover 120 and the main body 110.

In the sectional view of Fig. 4, the seat 119 and the sealant material 140 are trapezoidal in cross-sectional shape, but other shapes are in general also possible, for example a shape of a circular sector or a rectangular shape. When the main body 110 and the cover 120 are joined together in the embodiment of Fig. 4, the sealant 140 is interposed between the top of the perimeter wall 118 and the cover 120, preventing contamination, for example dust, water or other pollutants, to the inner volume 130 from the external environment of the housing 100.

The housing 100 is normally subject to temperature variations, due to both self-heating of the electronic control unit and to variations in the climate conditions of the external environment. Accelerated tests to which electronic control units are subjected create even harsher temperature conditions. Differences in temperature between the sealed inner volume 130 and the external environment may cause also differences in pressure of a gas with which the inner volume 130 is filled.

Due to differences in the coefficients of thermal expansion of the main body 110 and of the sheet metal cover 120 and to positive or negative differences between internal and external pressure (overpressure or under-pressure, respectively), the housing 100 is subject to mechanical stress. Such stress may cause deformations of the sheet metal cover 120, which is thinner in comparison to the main body 110.

It is an object of the present invention to provide a housing for an electronic control unit, which has a particularly small risk of damage to the seal between the cover and the main body of the housing due to mechanical stress.

The object is achieved by a cover for a housing and by a housing according to the independent claims. The dependent claims describe advantageous developments and modifications of the invention.

According to a first aspect of the present invention, a cover for a housing for an electronic control unit is disclosed. The cover is in one embodiment a one-pieced sheet-metal part. In an alternative embodiment, it can be a plastic part, in particular a molded plastic part which may comprise a metallic liner or a metallic coating.

According to a second aspect, a housing for an electronic control unit which comprises the cover is disclosed. The housing is in particular configured according to at least one of the above-described embodiments. In particular, it further comprises a main body and a sealant.

The cover comprises a first border portion subject to contact a sealant. In other words, the first border portion - which may also be denoted as an edge portion - is configured and arranged for contacting the sealant.

The cover further comprises a second portion which is arranged adjacent to and in particular adjoining the first border portion. The deformability of the second portion is greater than the deformability of the first portion.

According to one embodiment, the cover comprises a third portion adjacent to the second portion, the deformability of the second portion being greater than the deformability of the third portion, the second portion being interposed between the first portion and third portion. Preferably, the third portion is a central portion of the cover. In an expedient embodiment, the first border portion extends circumferentially - preferably completely circumferentially - around the central portion in top view of the cover. The top view is in particular a view onto the main plane of extension of the cover. The first portion may in particular be laterally separated from the central portion by the second portion, at least in places. In one development, the second portion extends completely circumferentially around the central portion between the first and third portions in top view of the cover.

Advantageously, the deformation of the housing due to self-heating of the housing or to variations in the climate conditions of the external environment will predominantly deform the second portion. Deformation of the first portion which is in contact with the sealant may be particularly small. In particular, the second portion of the cover acts like a bellows, or a hinge, between the first and the third portion of the cover, allowing the central portion to deform, but isolating the first portion, which is in contact with the sealant, from deformation particularly well. Considering the fact that the second portion is not in contact with the sealant, the latter will not be affected by the deformation, thus allowing the isolation of the inner volume from the external environment to be maintained. The risk for damaging the seal due to deformation of the cover is thus particularly small. The present invention, therefore, creates a local soft region (i.e. the second portion of the cover) of preferred deformation, which isolates the sealant from deformation particularly well.

In contrast thereto, the cover deformation is directly acting on the sealant material and creating stress on it in conventional housings. A stress above the limit typically concludes into an adhesion or cohesion sealant failure.

Additional fixations between the cover and the main body of the housing, provided to avoid permanent deformations and to limit the displacements to the elastic domain, can be advantageously be dispensed with.

For example, additional internal walls 112, 114 of the housing 100, rising from the base 115 and supporting the sheet metal cover 120 within the inner volume 130, as exemplary shown in Fig. 4 can be omitted. For example, the presence of additional internal walls 112, 114 limits the space available for the electronic circuit inside the inner volume 130. In addition, the presence of additional internal walls 112, 114 makes the main body 110 of the housing 100 more complex and therefore more expensive.

Additional fixation between the cover and the main body - such as a gluing material 141 (as between top of the internal wall 112 and the cover 120) or one or more screws 142, rivets or the like (as between internal wall 114 and the cover 120) exemplary shown in Fig. 4 - can be omitted. The presence of additional fixations between the sheet metal cover 120 and the main body 110 of the housing 100 makes the assembly operations of the housing 100 longer.

According to one embodiment, the second portion has a thickness smaller than the thickness of the first portion. The thickness is in particular the dimension perpendicular to the main plane of extension of the cover. The reduced thickness of the second portion promotes deformation thereof.

According to further embodiments, the first portion is planar. This means in particular that an inner main surface and an outer main surface of the first portion are generally flat and parallel.

The inner and outer main surfaces in particular face towards the inner volume and away from the inner volume, respectively.

According to further embodiments, the second portion has at least one of the following sections:
- a trapezoidally shaped section,
- a section having a V-shaped cross-section,
- a section having a U-shaped cross-section,
- a series of sections which are trapezoidally shaped or have a V-shaped or U-shaped cross-section, one of the sections being adjacent to the first portion. In particular, the sections follow one another in direction away from the first portion, e.g. in direction from the first to the third portion. A "trapezoidally shaped section" is in particular to be understood to be represented by a groove of the cover which has inclined sidewalls being oriented in such fashion that the groove tapers from an opening to a bottom wall of the groove. In a cross-sectional view of the groove, the opening and the bottom wall represent the bases of the trapezoid and the sidewalls represent the legs of the trapezoid. Preferably, an inner main surface and an outer main surface of the bottom wall are flat and parallel to the inner and outer main surfaces of the first portion, respectively. In the case of section with a V-shaped cross-section, the groove preferably does not have the bottom wall, but the sidewalls merge at the bottom of the groove, opposite the opening.

According to one embodiment, the second portion comprises a section with a plurality of linear consecutive segments arranged in a bellows-like configuration. In other words, the second portion may have a zigzag-shaped cross-section.

According to another embodiment, the first portion and the third portion of the cover are coplanar. This means in particular that an inner main surface and an outer main surface of the third portion are generally flat and parallel and in particular lie in the same planes as the inner and outer main surfaces of the first portion, respectively.

According to one embodiment, the cover is positioned on the main body to define an inner volume of the housing. The sealant is arranged between the cover and the main body, specifically between the main body and the first portion. That the cover is positioned "on" the main body includes embodiments in which there is a gap between the main body and the cover, the gap preferably being bridged by the sealant and/or other components of the electronic control unit such as an electrical connector. The cover is fixed to the housing by means of the sealant.

### Brief Description of the Drawings

The aspects defined above and further aspects of the present invention are apparent from the examples of embodiment to be described hereinafter and are explained with reference to the exemplary embodiments. The invention will be described in more detail hereinafter with reference to exemplary embodiments to which the invention is not limited. Rather, it comprises any combination of elements of different embodiments. Moreover, the invention comprises any combination of claims and any combination of features disclosed by the claims.
Fig. 1 is a sectional view of a housing for an electronic control unit according to the present invention,
Fig. 2 is a top view of the housing in Fig. 1,
Fig. 3 schematically shows four different possible embodiments of a portion of a cover for the housing of Fig. 1,
Fig. 4 is a sectional view of a housing for an electronic unit.

### Detailed Description

**Fig. 1** shows a housing 10 for electronic units according to the present invention. The housing 10 comprises a main body 11 and a cover 12 joined together. The main body 11 is made of a plastic or metal material. The cover 12 is typically made of a generally flat metal sheet, of the same or of a different material with respect to the main body 11.

The main body 11 has a base 15 and a perimeter wall 18 rising from the base 15. The base 15, seen from a top view on an opening of the main body 11 which opening is surrounded by the perimeter wall 18 and covered by the cover 12, has a rectangular shape. According to different embodiment of the present invention, the base 15 may have a different shape, for example circular. The perimeter wall 18 is orthogonal to the base 15. According to different embodiments of the present invention (not shown) the perimeter wall 18 may be otherwise inclined with respect to the base 15.

On top of the perimeter wall 18, the cover 12 is supported and fixed in order to create a hollow structure with an inner volume 30 delimited by the base 15, the perimeter wall 18 and the cover 12 at least in places. The electronic control unit may comprise an electrical connector (not shown) which covers a lateral opening of the main body 11 and contributes to delimit the inner volume 30. The inner volume 30 is subject to house a plurality of electronic components (not shown).

On top of the perimeter wall 18 the main body 11 includes a seat 19 for a sealant material 40, for example constituted by an O-ring or - preferably and in the present embodiment - a formed-in-place gasket made from a fluid sealing compound. The seat 19 and the sealant material 40 are trapezoidal in cross-sectional shape, but other shapes are in general also possible, for example shapes as a circular sector or a rectangle.

When the main body 11 and the cover 12 are joined together, the sealant 40 is interposed between the top of the perimeter wall 18 and the cover 12, preventing contamination, for example dust or other pollutants, to the inner volume 30 from the external environment.

Fig 2 shows a top view of the cover 12 which has the same basic shape and lateral dimensions as the base 15. The cover 12 comprises three portions:
- a first planar border portion 21 subject to contact with the sealant 14,
- a second portion 22a, annular in shape and adjacent to the first border portion 21, in such a way that the first border portion 21 surrounds the second annular portion 22a, and
- a third planar central portion 23 adjacent to the second portion 22a in such a way that the second portion 22a is interposed between the first portion 21 and the third portion 23. The third central portion 23 is coplanar with the first portion 21.

The deformability of the second portion 22a is greater than the deformability of the first portion 21 and of the third portion 23, in order that, when thermal deformations are generated, the central portion 23 is allowed to be displaced, but the first portion 21, which is in contact with the sealant 40, is isolated from deformation by means of the second portion 22a which acts as a hinge between the first portion 21 and the third portion 23.

According to another possible embodiment of the present invention (not shown), the second portion 22a is not annular - i.e. in particular extends completely circumferentially around the third portion - but extends only partially along the first border portion 21. For example the second portion 22a may extend only along one, or two, or three of the lateral sides of the cover 12. According to another possible embodiment of the present invention (not shown), the third central portion 23 is not present and the second deformable portions extends from the center of the cover 12 to the first border portion 21

To achieve a deformability value greater than the deformability of the first portion 21 and of the third portion 23, the second portion 22a has a thickness lower than the thickness of the first portion 21.

Additionally or alternatively, the second portion 22a has a trapezoidally shaped section, comprising three consecutive linear segments 25 and four corners 26, linking the segments 25 with one another and with the first and third portions 21, 23 of the cover 12 (see the left portion of Fig. 1). The trapezoidally shaped section of the second portion 22a comprises:
- a first segment 25 (i.e. a sidewall) inclined with respect to the first portion 21 towards the inner volume 30 and linked to the first portion 21 by means of a first corner 26,
- a second segment 25 (i.e. a bottom wall) parallel to the first portion 21 and linked to the first segment 25 by means of a second corner 26,
- a third segment 25 (i.e. a further sidewall) linked to the second segment 25 by means of a third corner 26 and linked to the third portion 23 by means of a fourth corner 26.

The first and fourth corners 26 of the trapezoidal cross-section define an opening of the groove which groove represents the trapezoidally shaped section of the second portion 22a.

With reference to **Fig. 3****,** four alternative embodiments 22b, 22c, 22d, 22e for the section of second portion 22a are shown.

In a second embodiment, the second portion 22b has a section with a V-shaped cross-section, which comprises:
- a first segment 25 (i.e. a sidewall) inclined with respect to the first portion 21 towards the inner volume 30 and linked to the first portion 21 by means of a first corner 26,
- a second segment 25 (i.e. a further sidewall) linked to the second segment 25 by means of a second corner 26 and linked to the third portion 23 by means of a third corner 26.

In a third embodiment, the second portion 22c exhibits a W-shaped cross-section, being composed of two consecutive sections having a V-shaped cross-sections, as described in connection with the first alternative embodiment 22b, the tips of both V-shapes extending towards the inner volume 30.

In a fourth embodiment, the second portion 22d exhibits a Zshaped cross-section, being composed of two consecutive sections with V-shaped cross-section, like that of first alternative embodiment 22b, one tip extending towards the inner volume 30 and the other tip towards the external environment so that, in particular, adjoining sidewalls of the first and second section extend one another in smooth and flat fashion.

In a fifth embodiment, the second portion 22e is composed by two trapezoidal sections in series, one of the trapezoidal sections being adjacent to the first portion 21 and having its bottom wall displaced towards the inner volume 30 relative to the first portion 21, the other trapezoidal section being adjacent to the third portion 23 and having its bottom wall displaced towards the external environment relative to the first portion 21.

According to other embodiments of the present invention (not shown) the second portion 22a comprises a section having, in a cross-sectional view, a plurality of linear consecutive segments 26 connected by corners, for example in order to be arranged in a bellows-like configuration.

In general any configuration of shape, for example a curved shape, and thickness may be used in the second portion 22a of the cover 12 for obtaining the feature of the present invention, i.e. a portion of preferred deformation, which prevents the portion in contact from the sealant to deform and to transmit such deformation to the sealant itself.

## Claims

1. A cover (12) for a housing (10) for an electronic control unit comprising:
- a first border portion (21) for contacting a sealant (14) and
- a second portion (22a, 22b, 22c, 22d, 22e) adjacent to the first border portion (21),
wherein the deformability of the second portion (22a, 22b, 22c, 22d, 22e) is greater than the deformability of the first portion (21).

2. A cover (12) according to claim 1, wherein the cover (12) comprises a third portion (23) adjacent to the second portion (22a, 22b, 22c, 22d, 22e), the deformability of the second portion (22a, 22b, 22c, 22d, 22e) being greater than the deformability of the third portion (23), the second portion (22a, 22b, 22c, 22d, 22e) being interposed between the first portion (21) and third portion (23).

3. A cover (12) according to claim 2, wherein the first portion (21) and the third portion (23) of the cover (12) are coplanar.

4. A cover (12) according to claim 2 or 3, wherein, in top view of the cover (12), the third portion (23) is a central section of the cover (12), the first border portion (21) extends circumferentially around the third portion (23) and is laterally separated from the third portion (23) by the second portion (22a, 22b, 22c, 22d, 22e) at least in places.

5. A cover (12) according to one of the preceding claims, wherein the cover (12) is a one-pieced sheet-metal part.

6. A cover (12) according one of the preceding claims, wherein the second portion (22a, 22b, 22c, 22d, 22e) has a thickness smaller than the thickness of the first portion (21).

7. A cover (12) according one of the preceding claims, wherein, the first portion (21) is planar and the second portion (22a) has a trapezoidally shaped section.

8. A cover (12) according to one of claims 1 to 6, wherein, the first portion (21) is planar and the second portion (22e) has a series of trapezoidally shaped sections, one of the sections being adjacent to the first portion (21).

9. A cover (12) according one of claims 1 to 6, wherein, the first portion (21) is planar and the second portion (22b) has a V-shaped cross-section.

10. A cover (12) according to one of claims 1 to 6, wherein, the first portion (21) is planar and the second portion (22c, 22d) has a series of sections having a V-shaped cross-section, one of the sections being adjacent to the first portion (21).

11. A cover (12) according to one of the preceding claims, wherein the second portion (22a, 22b, 22c, 22d, 22e) comprises a zigzag-shaped cross-sectional shape.

12. A housing (10) for an electronic control unit, comprising
- a main body (11),
- a cover (12)according to at least one of the previous claims , and
- a sealant (14),
wherein
the cover (12) is positioned on the main body (11) for defining an inner volume (13) of the housing (10) and is fixed to the main body (11) by means of the sealant (14) being arranged between the cover (12) and the main body (11), the first portion (21) of the cover (12) being in contact with the sealant (14).
